# EUROPÄISCHE PATENTSCHRIFT

(11) **EP 0 428 785 B1**
(45) Veröffentlichungstag und Bekanntmachung des Hinweises auf die Patenterteilung: **16.02.1994**
(21) Anmeldenummer: 89121736.6
(22) Anmeldetag: 24.11.1989
(51) Int. Cl.: G11C 5/02, G11C 11/408, G11C 11/409

(54) **Halbleiterspeicher**
Semiconductor memory
Mémoire à semi-conducteurs

(43) Veröffentlichungstag der Anmeldung: 29.05.1991
(73) Patentinhaber: SIEMENS AKTIENGESELLSCHAFT, 80333 München (DE)
(72) Erfinder: Utesch, Matthias Christoph, Dipl.-Ing., D-8670 Hof/Saale (DE); Peisl, Martin, Dr.-Ing., D-8000 München 60 (DE)

(56) Entgegenhaltungen:
- EP-A- 0 130 798
- US-A- 4 796 224
- IEEE JOURNAL OF SOLID-STATE CIRCUITS, Band SC-19, Nr. 5, Oktober 1984,Seiten627-633, IEEE, New York, US; J. YAMADA et al.: "A submicron 1 Mbitdynamic RAMwith a 4-bit-at-a-time built-IN ECC circuit"

## Beschreibung

Die Erfindung betrifft einen Halbleiterspeicher auf einer rechteckförmigen Chipfläche, wobei
- der Halbleiterspeicher Dekoderblöcke, Peripherieschaltungsblöcke, Zellenfelder mit Wort- und Bitleitungen und eine von Zellenfeldern freie Fläche enthält,
- die Zellenfelder zu vier rechteckigen Zellenfeldblöcken zusammengefaßt sind,
- die Dekoderblöcke jeweils an einander gegenüberliegenden Rändern von je zwei Zellenfeldblöcken angeordnet sind,
- die Peripherieschaltungsblöcke innerhalb der von Zellenfeldern freien Fläche angeordnet sind, und
- Anschlußpads zum Verbinden des Halbleiterspeichers mit den Anschlüssen eines Gehäuses vorgesehen sind.

Die Entwicklung der Halbleiterspeicher ist in den letzten Jahren stetig vorangegangen. War noch vor wenigen Jahren der 256kBit-Chip Stand der Technik, so werden heute schon die ersten 4MBit-Chips bzw. 16MBit-Chips ausgeliefert. Jeder Generationswechsel der Halbleitersspeicher bedeutet dabei eine Vervierfachung der Speicherkapazität, wobei die Chipfläche meist nur um maximal das 1,5-fache größer wird. Dies bedeutet, daß die Strukturen des Halbleiterspeichers so klein werden, daß bei der Layouterstellung nachfolgend beschriebene Bedingungen eingehalten werden müssen.

Die Speicherzellen z.B. eines dynamischen Halbleiterspeichers sind in Zellenfeldern an Kreuzungspunkten von Wort- und Bitleitungen angeordnet. Jede Speicherzelle besteht aus einem Schalttransistor und einem Kondensator. Der Gateanschluß eines jeden Transistors ist mit einer Wortleitung verbunden. Der Kondensator einer Speicherzelle ist über die Laststrecke des Schalttransistors mit je einer Bitleitung verbunden. Über die Wortleitungen wird nun eine Spalte eines Zellenfeldes ausgewählt. Auf diese Weise werden den dieser Spalte zugeordneten Bitleitungen die jeweiligen Kapazitäten der angesprochenen Zellen dieser Spalte zugeschaltet. Eine erste Bedingung ist daher, daß die Bitleitungen möglichst kurz sind, um parasitäre Effekte bedingt durch zusätzliche Leitungskapazitäten zu vermeiden. Dies bedeutet, daß das Verhältnis von Zellkapazität zu Bitleitungskapazität zuzüglich der Junctionkapazität des Schalttransistors möglichst groß sein muß. Dies ist bei kurzen Bitleitungen gewährleistet.

Eine Möglichkeit, den Einfluß der Bitleitungskapazität zu verringern, besteht darin, Treiberstufen zwischen einzelne Zellenfelder zu schalten. Solche Treiberstufen können aber nicht in beliebiger Anzahl verwendet werden, da die Größe der Chipfläche durch die Gehäusegröße begrenzt ist. Eine weitere Bedingung ist, daß der Speicherchip montierbar sein muß, sowie daß die Lage der Pads zum Anschluß der Speicherchips an die Gehäuseanschlüsse die Bedingung der Bondbarkeit erfüllen.

Aus der "IEEE INTERNATIONAL Solid-State Circuits Conference 1989", Seiten 246 bis 249 und Seiten 352 bis 355 ist ein hochintegrierter 16MBit-Chip bekannt, bei dem das Layout derart gestaltet ist, daß die Pads am Chiprand liegen, daß die Zellenfelder in vier einfachen Zellenschaltblöcken rechteckig angeordnet sind, daß die Dekoderblöcke an einander gegenüberliegenden Rändern von je zwei einfachen Zellenfeldblöcken zwischen den gegenüberliegenden Dekoderblöcken angeordnet sind und daß die Peripherieschaltungsblöcke parallel zur kürzeren Chipseite innerhalb der freien Fläche zwischen den gegenüberliegenden Dekoderblöcken und an den Rändern der Chipfläche angeordnet sind.

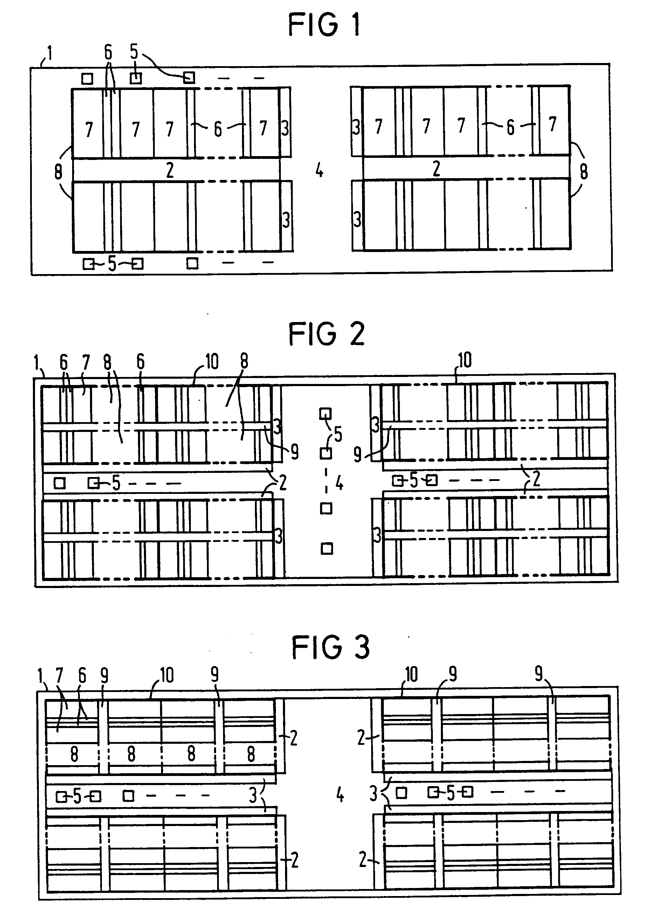

In FIG 1 ist die Aufsicht auf einen 16MBit-Halbleiterspeicherchip gemäß dem Stand der Technik dargestellt. Auf der rechteckförmigen Chipfläche 1 sind Zellenfelder 7 in vier einfachen Zellenfeldblöcken 8 rechteckig angeordnet. Parallel zur kürzeren Seite der einfachen Zellenfeldblöcke 8 sind zwischen den Zellenfeldern 7 Treiberstufen 6 angeordnet. An einander gegenüberliegenden Rändern von je zwei einfachen Zellenfeldblöcken 8 sind Dekoderblöcke 2, 3 angeordnet. An den kürzeren Seiten der einfachen Zellenfeldblöcke 8 befinden sich die Bitdekoder 3, und an der längeren Seite der einfachen Zellenfeldblöcke 8 befinden sich die Wortdekoder 2. Die zwischen je zwei einfachen Zellenfeldblöcken 8 liegenden Wortdekoder 2 bilden hier einen zusammenhängenden Block, wohingegen die freie Fläche 4 zwischen den Bitdekodern 3 und die restliche um die einfachen Zellenfeldblöcke 8 liegende freie Fläche 4 am Chiprand für Peripherieschaltungen genutzt werden kann. An den beiden Rändern der längeren Chipseite sind die Anschlußpads 5 angeordnet.

Diese Anordnung hat den Nachteil, daß die Leitungen zum Verbinden von Peripherieschaltungen bzw. der Anschlußpads 5 und anderen Schaltungsblöcken sehr lang werden. Außerdem kann bei höherer Integration die Länge der Wortleitungen in einen kritischen Bereich zu großer Wortleitungslaufzeit kommen.

Aufgabe der Erfindung ist es, eine Anordnung eines Halbleiterspeichers zu entwickeln, die einen möglichst kompakten Aufbau und eine minimale Chipfläche bei möglichst kleiner Wortleitungslaufzeit gewährleistet.
Diese Aufgabe wird bei dem eingangs genannten Halbleiterspeicher dadurch gelöst, daß
- die Zellenfelder zu vier kombinierten Zellenfeldblöcken zusammengefaßt sind,
- die vier Zellenfeldblöcke an den Ecken der Chipfläche angeordnet sind,
- die von Zellenfeldern freie Fläche zwischen den gegenüberliegenden Dekoderblöcken vorgesehen ist und
- daß die Anschlußpads innerhalb der von Zellenfeldern freien Fläche angeordnet sind.

Weiterbildungen der Erfindung sind Gegenstand der Unteransprüche.

Im folgenden wird die Erfindung anhand der Figuren 2 und 3 erläutert. Es zeigen dabei:
- FIG 2: ein erstes Ausführungsbeispiel eines erfindungsgemäßen Halbleiterspeichers,
- FIG 3: ein zweites Ausführungsbeispiel eines erfindungsgemäßen Halbleiterspeichers.

In FIG 2 ist die Aufsicht auf einen Halbleiterspeicherchip mit der erfindungsgemäßen Anordnung dargestellt. Hierbei handelt es sich um einen 64MBit-Halbleiterspeicherchip, bei dem nun vier kombinierte Zellenfeldblöcke 10 an den Ecken der Chipfläche 1 angeordnet sind. Innerhalb eines kombinierten Zellenfeldblocks 10 sind vier einfache Zellenfeldblöcke 8 rechteckig angeordnet, wobei jeder dieser einfachen Zellenfeldblöcke 8 einem Zellenfeldblock 8 des in FIG 1 beschriebenen 16MBit-Halbleiterspeicherchips entspricht. Innerhalb eines kombinierten Zellenfeldblocks 10 ist parallel zu dessen längeren Seite zwischen je zwei einfachen Zellenfeldblöcken 8 eine Treiberstufe 9 angeordnet. Diese Treiberstufe 9 verstärkt die Signale der Wortleitungen der einfachen Zellenfeldblöcke 8. An den gegenüberliegenden Rändern von je zwei kombinierten Zellenfeldblöcken 10 sind wiederum die Dekoderblöcke 2, 3 angeordnet, wobei die Wortdekoderblöcke 2 keinen zusammenhängenden Block bilden. Die für die Peripherieschaltungsblöcke nutzbare freie Fläche 4 liegt hier nur zwischen den Dekoderblöcken 2, 3. Die Anschlußpads 5 sind parallel zu den Wortdekoderblöcken 2 und/oder parallel zu Bitdekoderblöcken 3 innerhalb dieser freien Fläche 4 angeordnet.

FIG 3 zeigt ein weiteres Ausführungsbeispiel einer erfindungsgemäßen Anordnung anhand einer Aufsicht auf einen Halbleiterspeicherchip. Dieser ist im wesentlichen wie der in FIG 2 gezeigte Halbleiterspeicherchip aufgebaut. Es sind wiederum vier kombinierte Zellenfeldblöcke 10 vorgesehen, wobei ein kombinierter Zellenfeldblock 10 wiederum vier einfache der aus FIG 1 bekannten Zellenfeldblöcke 8 enthält. Diese sind hier nebeneinander angeordnet und gegenüber den in FIG 1 und FIG 2 dargestellten einfachen Zellenfeldblöcken 8 um 90° gedreht. Die Anordnung der kombinierten Zellenfeldblöcke 10 und der Dekoderblöcke 2, 3 entspricht dabei der in FIG 2 gezeigten mit dem Unterschied, daß die Bitdekoderblöcke 3 hier parallel zur längeren Seite der kombinierten Zellenfeldblöcke 10 liegen. Die Wortdekoderblöcke 2 liegen dementsprechend parallel zur kürzeren Seite der kombinierten Zellenfeldblöcke 10. Zwischen den ersten beiden einfachen Zellenfeldblöcken 8 und den letzten beiden einfachen Zellenfeldblöcken 8 eines jeden kombinierten Zellenfeldblocks 10 befindet sich jeweils eine Treiberstufe 9 für die Wortleitungssignale. Die freie Fläche 4 und die Anordnung der Anschlußpads 5 entspricht der in FIG 2 gezeigten.

Die in FIG 2 und FIG 3 gezeigte Anordnung gewährleistet kürzere Verbindungen zwischen den Anschlußpads 5 und den verschiedenen Schaltungsblöcken. Der Einfluß der Wortleitungslänge auf die Schaltzeiten wird durch Treiberstufen 9 verringert. Diese Anordnung ist nicht auf die Anwendung in 64MBit DRAM-Speichern beschränkt.

## Patentansprüche

1. Halbleiterspeicher mit einer rechteckförmigen Chipfläche (1), wobei
- der Halbleiterspeicher Dekoderblöcke (2, 3), Peripherieschaltungsblöcke, Zellenfelder (7) mit Wort- und Bitleitungen und eine von Zellenfeldern freie Fläche (4) enthält,
- die Zellenfelder (7) zu rechteckigen Zellenfeldblöcken (8) zusammengefaßt sind,
- die Dekoderblöcke (2, 3) jeweils an einander gegenüberliegenden Rändern von je zwei Zellenfeldblöcken angeordnet sind,
- die Peripherieschaltungsblöcke innerhalb der von Zellenfeldern freien Fläche (4) angeordnet sind,
- Anschlußpads (5) zum Verbinden des Halbleiterspeichers mit den Anschlüssen eines Gehäuses vorgesehen sind,
**dadurch gekennzeichnet**, daß
- die Zellenfeldblöcke zu vier kombinierten Zellenfeldblöcken (10) zusammengefaßt sind,
- die vier kombinierten Zellenfeldblöcke (10) an den Ecken der Chipfläche (1) angeordnet sind,
- die von Zellenfeldern freie Fläche (4) zwischen den gegenüberliegenden Dekoderblöcken (2, 3) vorgesehen ist,
- die Anschlußpads (5) innerhalb der von Zellenfeldern freien Fläche (4) angeordnet sind.

2. Halbleiterspeicher nach Anspruch 1,
**dadurch gekennzeichnet**, daß
die Bitleitungssignale der Zellenfelder (7) verstärkende Treiberstufen (6) zwischen den Zellenfeldern (7) angeordnet sind.

3. Halbleiterspeicher nach Anspruch 1,
**dadurch gekennzeichnet**, daß
Treiberstufen (9), die die Wortleitungssignale der Zellenfelder (7) verstärken, zwischen den Zellenfeldblöcken (8) angeordnet sind.

4. Halbleiterspeicher nach Anspruch 1,
**dadurch gekennzeichnet**, daß
die Bitleitungssignale der Zellenfelder (7) verstärkende Treiberstufen (6) zwischen den Zellenfeldblöcken (8) angeordnet sind.

## Claims

1. Semiconductor memory having a rectangular chip surface (1), in which
- the semiconductor contains decoder blocks (2, 3), peripheral circuit blocks, cell fields (7) having word and bit lines, and a surface area (4) free of cell fields,
- the cell fields (7) are combined to form rectangular cell field blocks (8),
- the decoder blocks (2, 3) are arranged in each case on mutually opposite edges of two cell field blocks in each case,
- the peripheral circuit blocks are arranged within the surface area (4) free of cell fields,
- terminal pads (5) for connecting the semiconductor memory to the connections of a housing are provided,
characterized in that
- the cell field blocks are combined to form four combined cell field blocks (10),
- the four combined cell field blocks (10) are arranged at the corners of the chip surface (1),
- the surface area (4) free of cell fields is provided between the opposite decoder blocks (2, 3),
- the terminal pads (5) are arranged within the surface area (4) free of cell fields.

2. Semiconductor memory according to Claim 1, characterized in that driver stages (6) amplifying the bit line signals of the cell fields (7) are arranged between the cell fields (7).

3. Semiconductor memory according to Claim 1, characterized in that driver stages (9) which amplify the word line signals of the cell fields (7) are arranged between the cell field blocks (8).

4. Semiconductor memory according to Claim 1, characterized in that driver stages (6) amplifying the bit line signals of the cell fields (7) are arranged between the cell field blocks (8).

## Revendications

1. Mémoire à semiconducteurs comportant une surface rectangulaire de microplaquette (1), dans laquelle
- la mémoire à semiconducteurs comporte des blocs de décodeurs (2, 3), des blocs de circuits périphériques, des zones de cellules (7) comportant des lignes de transmission de mots et des lignes de transmission de bits, et une surface (4) ne comportant aucune zone de cellules,
- les zones de cellules (7) sont réunies pour former des blocs rectangulaires (8) de zones de cellules,
- les blocs de décodeurs (2,3) sont disposés respectivement contre des bords, situés en vis-à-vis, de respectivement deux blocs de cellules de zones de cellules,
- les blocs de circuits périphériques sont disposés à l'intérieur de la surface (4) ne comportant aucune zone de cellules,
- des plots de connexion (5) sont prévus pour relier la mémoire à semiconducteurs aux bornes d'un boîtier,
caractérisée par le fait que
- les blocs de zones de cellules sont réunis pour former quatre blocs combinés (10) de zones de cellules,
- les quatre blocs combinés (10) de zones de cellules sont disposés aux angles de la surface de microplaquette (1),
- la surface (4), qui ne comporte aucune zone de cellules, est disposée entre les blocs de décodeurs opposés (2, 3),
- les plots de connexion (5) sont disposés à l'intérieur de la surface (4) qui ne comporte aucune zone de cellule.

2. Mémoire à semiconducteurs suivant la revendication 1, caractérisée par le fait que des étages d'attaque (6), qui amplifient les signaux des lignes de transmission de bits des zones de cellules (7), sont disposés entre les zones de cellules (7).

3. Mémoire à semiconducteurs suivant la revendication 1, caractérisée par le fait que des étages d'attaque (9), qui amplifient les signaux des lignes de transmission de mots des zones de cellules (7), sont disposés entre les blocs (8) de zones de cellules.

4. Mémoire à semiconducteurs suivant la revendication 1, caractérisé par le fait que des étages d'attaque (6), qui amplifient les signaux des lignes de transmission de bits des zones de cellules (7), sont disposés entre les blocs (8) des zones de cellules.
